# EUROPEAN PATENT SPECIFICATION

(11) **EP 1 621 048 B1**
(45) Date of publication and mention of the grant of the patent: **08.10.2008**
(21) Application number: 04711141.4
(22) Date of filing: 13.02.2004
(51) Int. Cl.: H05B 3/14, H01L 21/00

(54) **MULTI-ZONE CERAMIC HEATING SYSTEM AND METHOD OF MANUFACTURE THEREOF**
MEHRZONEN-KERAMIKHEIZSYSTEM UND VERFAHREN ZU SEINER HERSTELLUNG
SYSTEME DE CHAUFFAGE EN CERAMIQUE MULTIZONE ET PROCEDE DE FABRICATION ASSOCIE

(30) Priority: 08.05.2003 US 431758
(43) Date of publication of application: 01.02.2006
(73) Proprietor: WATLOW ELECTRIC MANUFACTURING COMPANY, St. Louis, Missouri 63146-4039 (US)
(72) Inventor: LIN, Hongy, Chesterfield, MO 63017 (US); LASKOWSKI, Thomas, Pacific, MO 63069 (US); SMITH, Jason, E., St. Louis, MO 63119 (US); BLOCK, Daniel, J., Imperial, MO 63052 (US)
(74) Representative: Knapp, Thomas
(86) International application number: PCT/US2004/004251
(87) International publication number: WO 2004/102076

(56) References cited:
- WO-A-02/089531
- US-A- 4 845 061
- US-A- 5 635 093
- US-A- 5 881 208
- US-A- 6 133 557
- US-A1- 2002 186 967
- US-A1- 2003 034 341
- US-A1- 2003 054 147
- US-B1- 6 469 283
- US-B2- 6 376 811
- US-B2- 6 486 447

## Description

### BACKGROUND OF THE INVENTION

### 1. Field of the Invention

The present invention relates to a heating system for use in a semiconductor processing such as in a Chemical Vapor Deposition (CVD) and etching environment, and more particularly to a heating system having a ceramic heater with a plurality of individually controlled heating zones. More specifically, the present invention relates to a ceramic heater having heating elements operatively associated with one or more sensors embedded in the ceramic substrate of the ceramic heater.

### 2. Prior Art

During the process of manufacturing a semiconductor wafer in a CVD and etching process it is important that the heating system maintain a uniform temperature along the entire surface of the semiconductor wafer. If a uniform temperature is not maintained along the entire surface of the semiconductor wafer, the manufacturing process is compromised and the quality of the semiconductor wafer is diminished. However, a CVD and etching environment is a harsh chemical environment containing highly corrosive gases, such as oxygen, chlorine and fluorine series gases, that may impact and cool only one portion of the exterior surface of the semiconductor wafer, therefore making it difficult to maintain a uniform temperature along the exterior surface of the wafer by the ceramic heater.

Because many ceramic heaters of the prior art normally include a single temperature sensor, such heaters cannot provide a constant and uniform heat distribution along the entire surface of the semiconductor wafer when cooler gas impact only a portion of the semiconductor wafer. Further, the highly corrosive CVD and etching environment eventually degrades and corrodes temperature sensing arrangements having multiple temperature sensors and electrical leads located along the exterior surface of the ceramic heater in order to detect temperatures along multiple zones of the ceramic heater surface. Other prior art devices teach a centrally located temperature sensor disposed inside a centralized hollow shaft of the ceramic heater in order to protect the leads and prevent corrosion of the sensor arrangement; however, this prevents accurate temperature readings along multiple portions of the semiconductor wafer surface since a single sensor can only take readings from the center portion of the ceramic heater because of the centralized location of the sensor.

Accordingly, ceramic heaters for use in the manufacture of semiconductor wafers suffer from several principal drawbacks. First, such heaters are unable to provide a sensor arrangement that can take temperature readings along the peripheral portions of the ceramic heater such that a uniform and constant temperature can be maintained along the entire surface of the semiconductor wafer because of the prolonged exposure of the temperature sensors to the corrosive gases contained in a CVD and etching environment seriously degrades the sensor's capabilities over time. Second, prior art ceramic heaters have heating elements that are manufactured from refractory metal materials make the heating element of the ceramic heater inefficient and costly to operate. This inefficiency is caused by a high Temperature Coefficient of Resistance ("TCR") exhibited by the prior art heating elements which can cause an undesirable high "rush in" current during start-up of the ceramic heater which makes power management more costly and inefficient.

For example, U.S. Patent 6,066,836 to Chen et al. discloses a prior art ceramic heater for use in a CVD and etching environment having one sensor to take temperature readings which are relayed to a microprocessor in order to adjust the temperature of various heating elements in the ceramic heater. Since only one sensor is utilized in the Chen et al. device it can only sense the temperature along the central portion of the semiconductor wafer and cannot maintain a uniform heat distribution along the entire surface of the semiconductor wafer. Additionally, this type of ceramic heater includes a heating element that suffers from a high TCR which causes the ceramic heater to be inefficient when operated.

U.S. Patent Application Publication No. 2002/0134775 to Ohashi discloses a ceramic heater with two distinct heating zones controlled by sensors located along the outer and peripheral portions of the ceramic heater. The Ohashi sensors are located in aluminum nitride tube members formed through the ceramic substrate of the ceramic heater that still expose the sensors to the corrosive effects of gases in a CVD and etching environment. As noted above, prolonged exposure to such gases eventually degrades the performance of the sensors and prevents the ceramic heater from achieving a uniform temperature along the entire surface of the semiconductor wafer. Furthermore, such a sensor arrangement may also cause a heat sink effect that compromises the temperature uniformity of the heater due to heat loss through conduction. Also, this reference does not teach or suggest the incorporation of a heating element made from a material that exhibits a low TCR during operation.

US 2002/186967 discloses a heating member having a RTD sensor and a heating element supported on top of a ceramic substrate formed by layers of different materials. WO 02/089531 A1 describes an apparatus for controlling a spatial temperature distribution having a chuck for a plasma processor with a temperature controlled base. US 2003/0034341 A2 describes a ceramic heater including a ceramic substrate having heating bodies and thermocouples. US 2003/0054147 A1 describes a ceramic substrate comprising a conductive layer disposed internally or on the surface thereof.

Therefore, there appears a need in the art for a ceramic heater comprising a plurality of distinct and independently controlled heating zones operatively associated with sensors that are completely and directly embedded inside the ceramic substrate of the heater in order to protect the sensor elements from the corrosive effects of gases in a CVD and etching environment. Furthermore, there also appears a need in the art for a ceramic heater that has a heating element made of material which exhibits a low TCR that is efficient to operate.

### OBJECTS AND SUMMARY OF THE INVENTION

Accordingly, the primary object of the present invention is to provide a heating system including a multi-zone ceramic heater that maintains a constant and uniform temperature along the surface of a semiconductor wafer in a CVD and etching environment.

Another object of the present invention is to provide a ceramic heater having a heating element made of a ceramic composite material consisting of molybdenum and aluminum nitride.

Another further object of the present invention is to provide a heating element that exhibits a low temperature coefficient of resistance.

Yet another object of the present invention is to provide a ceramic heater having temperature sensors and heating elements that are completely and directly embedded in the ceramic substrate of the heater.

Another object of the present invention is to provide a method of manufacturing a ceramic heater that completely encases the electrical components in the ceramic substrate of the ceramic heater in order to prevent corrosion of such components in a corrosive working environment.

These and other objects of the present invention are realized in the preferred embodiment of the present invention, described by way of example and not by way of limitation, which provides for a heating system with a multi-zone ceramic heater having embedded sensor and heating element arrangements that protect these elements from the corrosive CVD and etching environment as well as provide a heating element that exhibits a low temperature coefficient of resistance.

In brief summary, the present invention overcomes and substantially alleviates the deficiencies in the prior art by providing a heating system with a ceramic heater having plurality of heating elements in operative association with at least one temperature sensor. Each temperature sensor is dedicated to one particular heating zone and is capable of sensing the temperature at a particular location of the heater and communicate such temperature readings to a microprocessor. The microprocessor adjusts the heat generated at a respective heating element in a particular heating zone in order to maintain a constant and uniform temperature along the wafer. For example, if one portion of the semiconductor wafer is too cool due to the impact of cool gases along a portion of the semiconductor wafer the sensor in a particular heating zone detects the cooler temperature in the ceramic heater. The sensor then transmits a signal to the microprocessor for increasing the power to heating elements of that heating zone for increasing the amount of heat applied to that particular portion of the semiconductor wafer until a uniform temperature pattern is achieved along the surface of the wafer. The multi-zone arrangement of sensors along the entire ceramic heater is made possible because the sensors and heating elements are completely and directly embedded inside the ceramic substrate during manufacture without exposing any of the electrical components to the corrosive CVD and etching environment.

The ceramic heater according to the present invention is comprised of a ceramic substrate which is manufactured using a layering process wherein a series of ceramic layers are constructed from a composite material that is laminated and sintered. All of the ceramic layers are constructed of aluminum nitride with two of the ceramic layers having additional composites of molybdenum and aluminum nitride to form the sensor and heating element arrangements of the invention.

The multi-zone heating element arrangement is manufactured by splicing a pre-formed resistor tape that is cut into a particular design that may be spliced into the tape made of aluminum nitride that produces the ceramic layer. Preferably, these heating elements are constructed from a molybdenum and aluminum nitride composite. The inventors have discovered that the use of a molybdenum and aluminum nitride composite material for the manufacture of heating elements produces a heating element that exhibits a significantly lower TCR than prior art heating elements. This lower TCR allows the heating elements to have a lower "rush in" current during start-up when power is first supplied to the ceramic heater, thereby increasing the heater's operational efficiency.

The heating elements of the present invention are controlled by a microprocessor which communicates with a plurality of sensor arrangements that are also embedded directly within the ceramic substrate of the ceramic heater during manufacture. Power is supplied to the sensor and heating element arrangements through respective conductive pathways formed through the ceramic substrate of the ceramic heater that engage lead wires fed through the hollow shaft of the heater. The temperature sensors are preferably Resistive Temperature Detecting Devices that are applied directly on the surface of the tape used to produce one of the ceramic layers using a composite material that is constructed from molybdenum and aluminum nitride. Each temperature sensor is manufactured by applying a molybdenum and aluminum nitride ink to form a specifically designed pattern on the surface of one of the ceramic layers. The ink is applied so that it communicates with a conductive pathway formed through the ceramic substrate to supply power and communicate temperature readings to the microprocessor.

Additional objects, advantages and novel features of the invention will be set forth in the description that follows, and will become apparent to those skilled in the art upon examination of the following more detail description and drawings in which like elements of the invention are similarly numbered throughout.

### BRIEF DESCRIPTION OF THE DRAWINGS

FIG. 1 is a perspective view of the heating system showing the ceramic heater and the microprocessor according to the present invention;

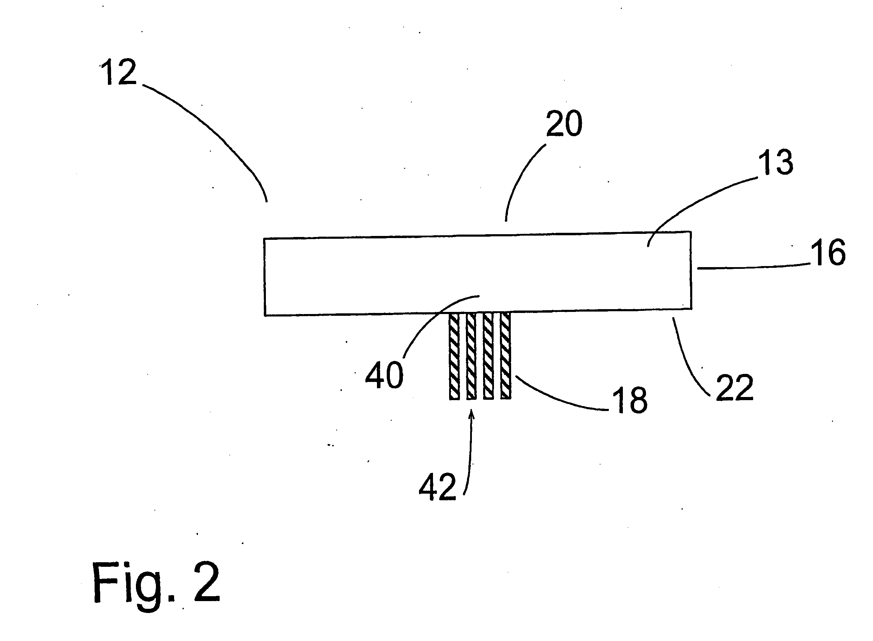

FIG. 2 is a side view of the ceramic heater according to the present invention;
FIG. 3 is a cross sectional view of the ceramic heater taken along line 3-3 of FIG. 1 according to the present invention;
FIG. 4 is a top view of one of the layers of tape that comprise the ceramic heater showing the heating elements spliced into the aluminum nitride composite according to the present invention;
FIG. 5 is a top view of the one of the layers of tape that comprise the ceramic heater showing the temperature sensors being applied to the layer of aluminum nitride composite according to the present invention;
FIG. 6 is an exploded view of the ceramic heater depicting the series of ceramic layers that comprise the ceramic substrate according to the present invention;
FIG. 7 is a table comparing the temperature coefficient of resistance of a prior art heating element against that of a heating element made of a molybdenum and aluminum nitride composite according to the present invention; and
FIG. 8 is a table which shows that resistance increases with rising temperature for an embedded sensor according to the present invention.

### DETAILED DESCRIPTION OF THE INVENTION

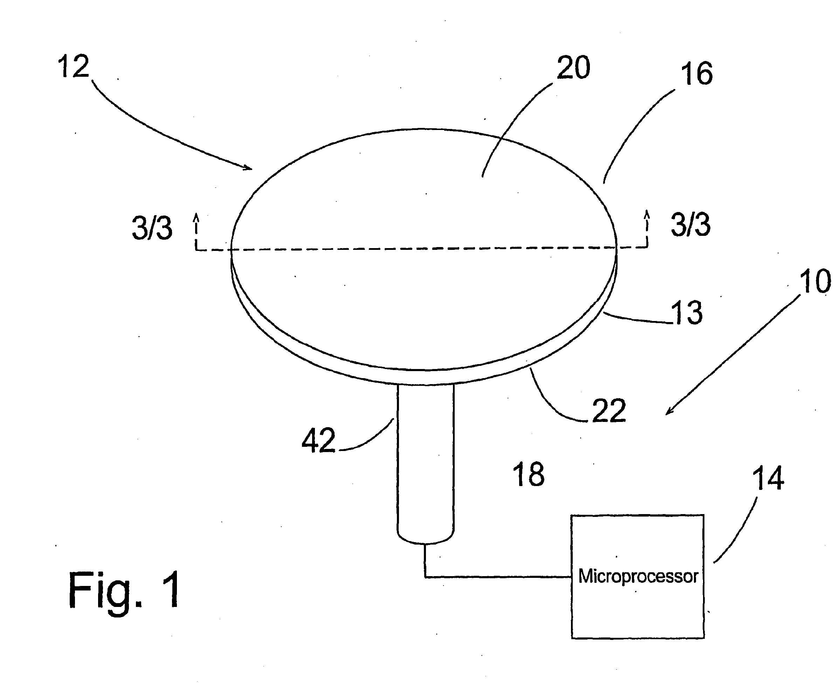

Referring to the drawings, the preferred embodiment of the multi-zone heating system for use in a CVD and etching environment according to the present invention is illustrated and generally indicated as 10 in FIG. 1. Heating system 10 provides a means for maintaining a uniform and constant temperature along a surface of a semiconductor wafer (not shown), while protecting the electrical components of the heating system from the corrosive gases in the CVD and etching environment.

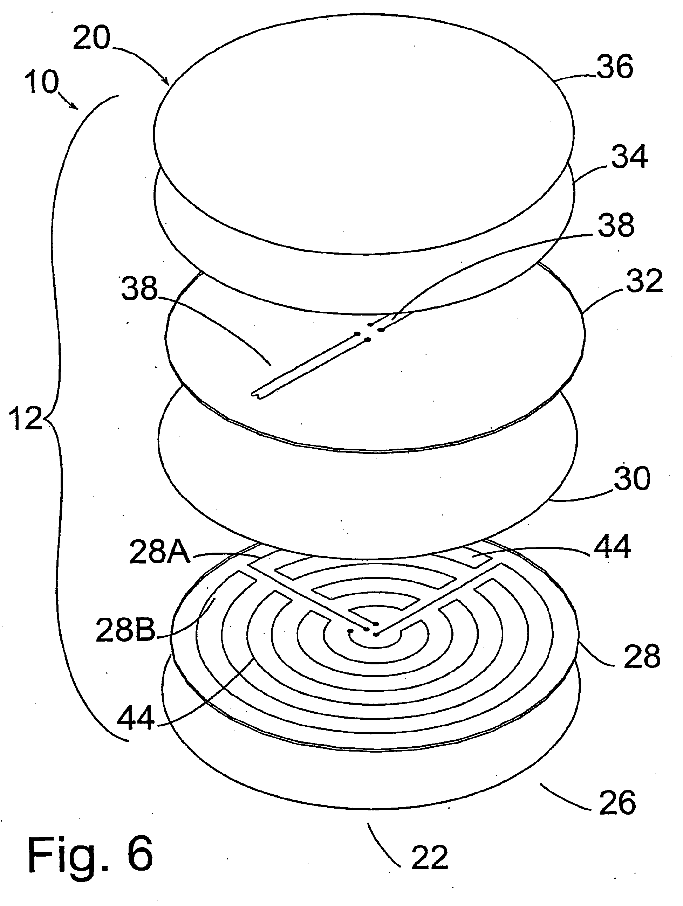

Referring to FIGS. 1 and 6, ceramic heater 12 comprises a ceramic body 16 having a generally disk-like configuration attached to a hollow shaft 18. Ceramic body 16 is made of a ceramic substrate constructed from a series of ceramic layers 26, 28, 30, 32, 34 and 36 made from an electrically conductive composite material having at least two or more heating elements 44 completely and directly embedded in the ceramic substrate with at least one temperature sensor 38 in operative association with one or more heating elements 44 through a microprocessor 14. Ceramic layers 26, 28, 30, 32, 34, and 36 are laminated and sintered together during manufacture which forms a ceramic body 16 that completely and directly embeds heating elements 44 and temperature sensors 38 in the ceramic substrate of ceramic heater 12 as shall be explained in greater detail below.

Referring to FIG. 1, heating elements 44 are operably controlled by a microprocessor 14. When temperature sensors 38 sense that one area of the heater is too cold due to a temperature drop in semiconductor wafer or too warm such that a variance in temperature has occurred, the microprocessor 14 will increase or decrease power to specific heating elements 44 in order to provide and maintain a uniform temperature distribution across the entire surface of the semiconductor wafer.

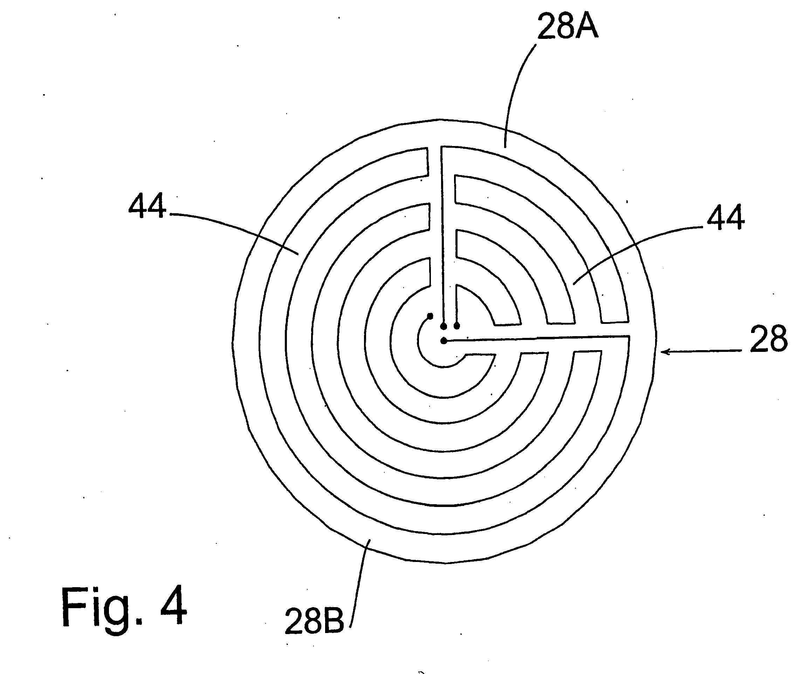

As illustrated in FIG. 4, maintaining a uniform temperature along the semiconductor wafer is achieved by the grouping of the heating elements 44 within discrete heating zones 28A and 28B along the ceramic layer 28 of body 16. During manufacturing, heating elements 44 and temperature sensors 38 are completely embedded within the ceramic substrate by application of heating elements 44 and temperature sensors 38 on respective ceramic layers that comprise ceramic body 16.

Referring to FIG. 6, the ceramic body is constructed of ceramic layers 26, 28, 30, 32, 34, and 36 which are laminated and then sintered together during manufacture. It should be noted that any number of ceramic layers could be used to construct ceramic heater 12 and still fall within the scope of the invention. In the preferred embodiment, thick tapes are used to manufacture the ceramic layers 28 and 32 having heating elements 44 and temperature sensors 38 which are interposed between the other ceramic layers 26, 30, 34 and 36 formed from thick tapes.

The tapes used to make ceramic layers 26, 30, 34 and 36 are constructed from aluminum nitride, while the tapes for ceramic layers 28 and 32 are also formed from the same aluminum nitride, but are used to form the base for heating elements 44 and temperature sensors 38, respectively. Ceramic layer 28 further includes an additional composite material spliced with the aluminum nitride of the thick tape to form at least two separate heating zones 28A and 28B made preferably from a molybdenum and aluminum nitride composite. Further, ceramic layer 32 includes a molybdenum and aluminum nitride ink that is applied directly to the surface of the ceramic layer 32 which will form the temperature sensors 38.

As noted above, ceramic layer 28 forms a multi-zone heating element arrangement made by splicing a molybdenum and aluminum nitride composite that will function as heating elements 44 with a tape made from an aluminum nitride composite. Preferably, the volume percentage ratio of molybdenum to aluminum nitride in the composite material can be in a range of 20%-55% molybdenum to 80%-45% aluminum nitride. This heating element composite is cut out from the composite tape to produce at least two separate heating elements 44 and spliced into the tape made from the aluminum nitride to form separate heating zones. As shown in FIG. 4, the splicing of the pre-formed cut-out into tape of ceramic layer 28 results in layer 28 being divided into two separate heating zones, 28A and 28B. Each heating zone 28A and 28B includes at least one separate and distinct heating element 44 that may be operated to provide and maintain a uniform temperature along the surface of the semiconductor wafer.

The inventors have also discovered that the construction of heating elements 44 from a molybdenum and aluminum nitride composite allows such elements 44 to have a lower TCR (i.e. 0.0015/°C) than heating elements 44 made from refractory metal such as molybdenum which has a higher TCR of 0.00435/°C. This lower TCR for heating elements 44 made from a molybdenum and aluminum nitrate composite produces a low "rush in" current when the ceramic heater 12 is first activated during start up, thereby making it more energy efficient to operate.

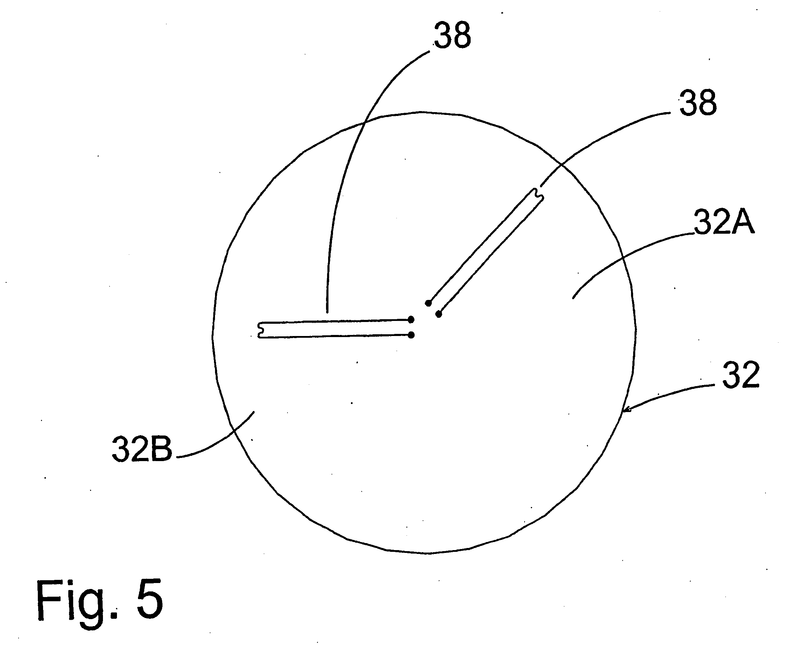

As noted above, heating elements 44 are operatively associated with at least one temperature sensor 38, respectively, which are located along ceramic layer 32 as shown in FIG. 5. Ceramic layer 32 is made from the same aluminum nitride composite that is utilized in ceramic layers 26, 30, 34, and 36 with the exception that a composite of molybdenum and aluminum nitride ink is applied to the surface of the aluminum nitride tape layer during manufacture to form temperature sensors 38. The ratio of molybdenum in temperature sensors 38 can be from 20%-100% molybdenum with the remainder being aluminum nitride. Most preferably, as noted above, this composite of molybdenum and aluminum nitride is in the form of a liquid ink mixture which is applied directly to the surface of the tape for ceramic layer 32 using methods known in the art. Therefore, when the ink is first applied to tape of ceramic layer 32 it will infiltrate a small portion of the aluminum nitride tape and the proportion of aluminum nitride in the ink will increase within the overall molybdenum and aluminum nitride composite that forms temperature sensor 38. Accordingly, even if 100% molybdenum is first applied, the temperature sensor will contain a small proportion of aluminum nitride derived from aluminum nitride infiltrating from the tape.

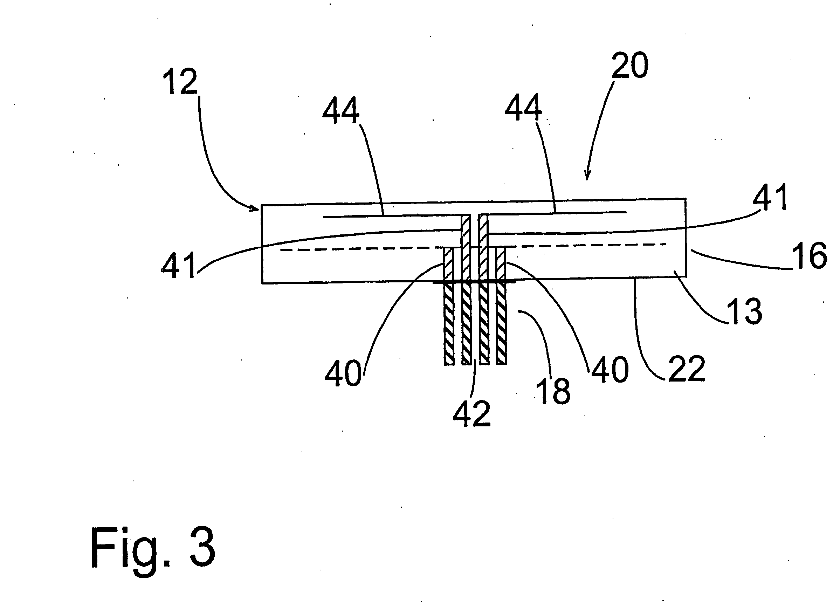

Referring to FIG. 3, temperature sensors 38 and heating elements 44 are connected to conductive pathways 40 and 41, respectively. Preferably, conductive pathways 40 and 41 are formed by boring axial pathways through ceramic body 16 that terminates adjacent to hollow shaft 18 for each heating element 44 and temperature sensor 38 of ceramic heater 12.

The axial pathways 40 and 41 are then completely back filled with a slug or powder of conductive material made from a molybdenum and aluminum nitride composite. Preferably, the conductive material has a ratio of molybdenum to aluminum nitride that is equal to the same ratio of molybdenum and aluminum nitride used in the construction of heating elements 44.

Connected to each of the conductive pathways 40 and 41 at its terminal point are a pair of lead wires 42 which are operatively associated with microprocessor 14 and a power source (not shown). Preferably, microprocessor 14 provides a means for receiving signals from temperature sensors 38 which is then converted to temperature readings based on a predetermined resistance vs. temperature calibration curve and automatically adjusts the power applied to respective heating elements 44 in heating zones 28A and 28B in order to maintain a constant and uniform temperature along the semiconductor wafer.

As noted above, ceramic heater 12 is manufactured by the creation of a tape for each ceramic layer 26, 28, 30, 32, 34, and 36 and the modification of the tapes for ceramic layers 28 and 32 to include heating elements 44 and temperature sensors 38, respectively. The initial process to construct tapes for ceramic layers 26, 28, 30, 32, 34, and 36 is similar for each tape. An aluminum nitride powder is mixed with organic binders and solvents, such as acrylic and toluene, to form a slurry. The slurry is cast by a doctor blade over a plastic carrier to allow the slurry to dry and form a tape.

As further noted above, ceramic layer 28 is manufactured from two separate tapes being cut and then spliced together to form heating elements 44. The first tape is comprised of aluminum nitride which is manufactured in an identical manner to the tapes used to produce ceramic layers 26, 30, 32, 34, and 36. The second tape is made from a molybdenum and aluminum nitride composite material and serves as the heating element portion of the ceramic layer 28. The volume percentage ratio of molybdenum is 20%-45% with the remainder of the composite being comprised of aluminum nitride. Once the two tapes for ceramic heater 28 have been created they are spliced together to form one continuous tape. The heating element portion now spliced within tape of ceramic layer 28 may comprise two or more separate and distinct heating zones made from a molybdenum and aluminum nitride composite which form heating elements 44 of ceramic heater 12. Preferably, at least two distinct heating elements 44 are spliced into the tape to allow for at least two individually controlled heating zones 28A and 28B, although the present invention contemplates that more than two heating zones may be produced.

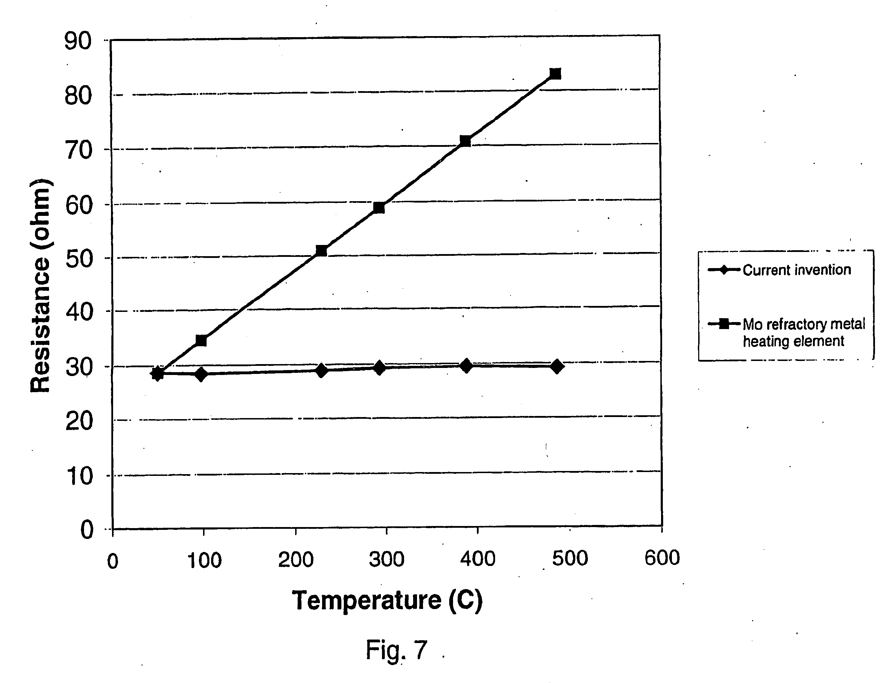

The splicing process is achieved by removing a set portion of the aluminum nitride from the tape and replacing it with an identical set portion cut from a tape containing a electrically conductive molybdenum and aluminum nitride composite that serves as heating element 44. Preferably, each respective tape may be cut by a laser, dye cut, or other known methods in the art. After the two tapes are cut each set portion should have a shape that is converse to the other. As shown in FIG. 4 the shapes are generally circular in the preferred embodiment, however any suitable configuration, such as angular, square or any combination of the above, is felt to fall within the scope of the present invention. When the set portions are spliced together each will interlock with one another to form a flat, continuous tape for ceramic layer 28 with heating elements 44 embedded within the ceramic substrate of ceramic heater 12. Referring to FIG. 7, heating elements 44 made in accordance with the present invention would have a much lower TCR than has been found in heating elements constructed from traditional refractory metals of the prior art. For example, a heating element constructed from only Molybdenum has a TCR as indicated on FIG. 7 of 0.00435/°C, while heating elements 44 made from a composite of molybdenum and aluminum nitride in accordance with the present invention have a TCR of 0.0001/°C which is significantly lower than prior art devices.

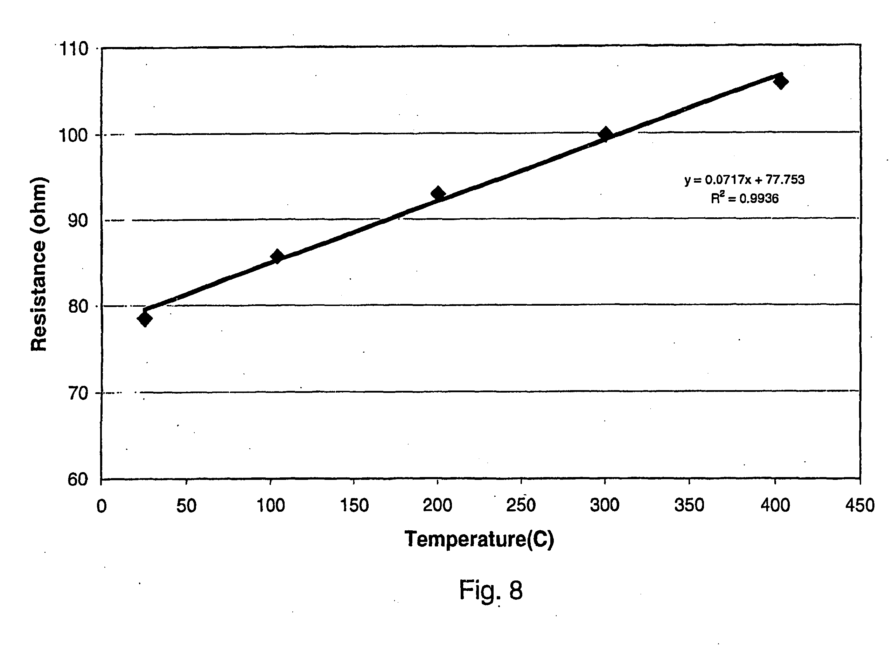

The temperature sensors 38 applied to ceramic layer 32 are formed from an ink which is a liquid mixture of molybdenum combined with aluminum nitride. The molybdenum and aluminum nitride ink is applied to the tape of ceramic layer 32 with a specific pattern and allowed to dry, thereby creating at least two temperature sensors 38. In the preferred embodiment, the number of temperature sensors 38 will be equal to at least the number of heating zones as each temperature sensor 38 will be operatively associated with at least one respective heating element 44 through microprocessor 14 as shall be explained in greater detail below. Referring to FIG. 8, temperature sensors 38 are preferably Resistive Temperature Detecting (RTD) devices that exhibit a level of resistance that is dependent upon the temperature.

Once tape of ceramic layer 32 has the molybdenum and aluminum nitride ink applied thereto and the tape of ceramic layer 28 is fabricated with heating elements 44 spliced therein, the next step is to assemble the tapes of ceramic layers 26, 28, 30, 32, 34, and 36 to form unitary ceramic body 16.

Referring to FIG. 6, the tapes of ceramic layers 26, 28, 30, 32, 34, and 36 are assembled with each tape being stacked one on top of the other in successive order. After the tapes have been properly stacked conductive pathways 40 and 41 are formed for each heating element 44 and temperature sensor 38, respectively, as shown in FIG. 3, for providing power and permitting operative association between the heating elements 44 and temperature sensor 38 through microprocessor 14. Conductive pathway 40 is formed for each heating element 44 by making a hole through the tape of ceramic layers 26 and 28. After the hole has been formed it is back filled with either a plug or powder made from a molybdenum and aluminum nitride composite similar to the composite used to make heating element 44. This backfill material forms conductive pathway 40 which links heating element 44 to lead wires 42 disposed inside hollow shaft 18. In similar fashion, conductive pathway 41 is formed by making a hole through the tape of ceramic layers 26, 28, 30 and 32 for each temperature sensor 38 which is also backfilled with a molybdenum and aluminum nitride composite material such that a conductive path is established between each temperature sensor 38 and lead wires 42. The ratio of molybdenum to aluminum nitride for the composite that forms conductive pathways 40 and 41 should be equal to that used to form heating elements 44 in the preferred embodiment of the invention.

After a suitable number of conductive pathways 40 and 41 are created, the tapes of ceramic layers 26, 28, 30, 32, 34, and 36 are laminated and sintered to create ceramic body 16. The lamination is accomplished by placing all of the stacked tapes in a conventional mold and then applying traditional lamination techniques to the surface of the tapes. Next, the ceramic layers 26, 28, 30, 32, 34, and 36 are sintered together at a temperature range of between 1700 to 1900 degrees centigrade under a pressure of between 100 to 3000 pounds per square inch. It should be noted that although specific ranges are given, any range of temperatures and pressures that would effectively sinter tapes together to form a ceramic substrate would fall within the scope of the present invention. Any known means of sintering the plates together, such as a hot isostatic press, can be used and still fall within the scope of the present invention.

After the sintering process is completed lead wires 42, preferably constructed of nickel, are brazed to each conductive pathway 40 and 41 and are then fed through hollow shaft 18 which is attached to ceramic body 16 by means well known in the art. The free ends of the lead wires 42 are then connected to microprocessor 14 which operatively associates the microprocessor 14 with heating elements 44 and temperature sensors 38 as well as a power source.

In operation, heating system 10 is capable of providing a constant and uniform temperature along the surface of the semiconductor wafer because of the multi-zone heating arrangement due to heating elements 44 and temperature sensors 38 being embedded along all portions of ceramic body 16. When a semiconductor wafer is first placed upon ceramic heater 12 certain portions of the wafer may become cooler than other portions due to the impact of cooler gases upon only a portion of the semiconductor wafer.

To correct this temperature variance across the surface of the semiconductor wafer, microprocessor 14 receives temperature readings from various temperature sensors 38 through a specifically designed wafer (not shown) with a calibrated curve that transforms a resistance signal into a temperature reading signal. The temperature sensor 38 then transmits a signal through lead wire 42 to respective heating elements 44 located in zone 28A (or 28B). A respective heating element 44 would then have its power adjusted by microprocessor 14 so that more heat is provided to a particular heating zone than was being applied to the other heating zone. This additional heating warms the area of the semiconductor wafer that was too cool due to the impact of cool gasses. Additional heat to that particular heating zone would continue until the temperature readings being transmitted from both heating zones 28A and 28B were substantially equal. Due to this balancing of temperatures between heating zones 28A and 28B the entire surface of the semiconductor wafer would remain at a constant temperature. Moreover, since heating elements 44 and temperature sensors 38 are completely and directly embedded within the ceramic substrate of body 16 they would not be subject to the corrosive environment of a CVD and etching environment.

It should be understood from the foregoing that, while particular embodiments of the invention have been illustrated and described, various modifications can be made thereto without departing from the spirit and scope of the invention. Therefore, it is not intended that the invention be limited by the specification; instead, the scope of the present invention is intended to be limited only by the appended claims.

## Claims

1. A ceramic heater (12) comprising:
a ceramic substrate (26-36), a heating element arrangement (44) and a temperature sensor arrangement (38), the temperature sensor arrangement (38) being operatively associated with said heating element arrangement (44),
**characterized in that;**
a) said ceramic substrate defines a single ceramic material;
b) said heating element arrangement (44) is directly embedded within said ceramic substrate (26-36); and
c) said temperature sensor arrangement (38) is completely embedded within said ceramic substrate (26-36); the ceramic substrate (26-36) and the temperature sensor arrangement (38) being infiltrated into one another to completely embed the temperature sensor arrangement (38) within the ceramic substrate (26-36).

2. The ceramic heater (12) of claim 1, further comprising a hollow shaft (18) attached to said ceramic substrate (26-36).

3. The ceramic heater (12) of claim 1, wherein said ceramic substrate (26-36) consists of an aluminum nitride ceramic composite.

4. The ceramic heater (12) of claim 1, wherein said temperature sensor arrangement (38) is operatively associated with said heating element arrangement (44) by a microprocessor (14).

5. The ceramic heater (12) of any of the preceding claims, wherein said heating element arrangement (44) is made from a material that exhibits a low temperature coefficient of resistance.

6. The ceramic heater (12) of claims 4 or 5, wherein said heating element arrangement (44) is interspliced within the ceramic substrate (26-36).

7. The ceramic heater (12) of any of preceding claims, wherein the heating element arrangement (44) defines a plurality of heating zones (28A, 28B) and the temperature sensor arrangement (38) includes a plurality of sensor elements operatively associated with the plurality of heating zones (28A, 28B) for individually measuring temperatures of the heating zones (28A, 28B).

8. The ceramic heater (12) of any of the preceding claims, further comprising a conductive pathway (40), which is connected to said heating element arrangement (44) and to said temperature sensing arrangement (38).

9. The ceramic heater (12) of any of preceding claims, further comprising a lead wire (42) connected to said conductive pathway (40), the lead wire (42) preferably constructed of nickel.

10. The ceramic heater (12) of claim 8 or claim 9,
wherein said temperature sensing arrangement (38), said heating element arrangement (44), or the conductive pathway (40) is comprised of a molybdenum and aluminum nitride composite.

11. A method of applying a constant and uniform heat source to an article, **characterized in that** the method comprises the steps of:
a) providing a ceramic heater (12) comprising:
i. a ceramic substrate (26-36) defining a single ceramic material,
ii. a heating element arrangement (44) directly embedded inside said ceramic substrate (26-36), the heating element arrangement (44) forming at least two independent and distinct heating zones (28A, 28B), and
iii. a temperature sensor arrangement (38) completely embedded within said ceramic substrate (26-36), the temperatures sensor arrangement (38) being operatively associated with said heating element arrangement (44), wherein the ceramic substrate (26-36) and the temperature sensor arrangement (38) are infiltrated into one another to completely embed the temperature sensor arrangement (38) within the ceramic substrate (26-36);
b) placing said article in communication with said ceramic heater (12);
c) allowing said temperature sensor arrangement (38) to detect differing temperatures along the surface of said article; and
d) adjusting said heating element arrangement (44) to eliminate said differing temperatures along said article.

12. The method of claim 11, wherein said article is a semiconductor wafer.

13. The method of claim 11, wherein said step of adjusting said heating element arrangement (44) is accomplished by a microprocessor (14) that is in operative control of said heating element arrangement (44).

14. The method of claim 11, wherein said step of eliminating said differing temperatures is accomplished by said heating element arrangement (44) providing more heat to cooler areas of said article and less heat to warmer areas of said article.

15. A method of manufacturing a ceramic heater (12) for heating a semiconductor wafer in a chemical vapor deposition and etching environment, **characterized in that** the method comprises the steps of:
a) providing a plurality of.layers (26-36) of tape ;
b) placing a heating element arrangement (44) in the form of a spliced tape within one of said plurality of layers (26-36) of tape;
c) applying a temperature sensing arrangement (38) to one of said plurality of layers (26-36) of tape;
d) placing said plurality of layers (26-36) of tape together; and
e) forming a ceramic composite from said plurality of layers (26-36) of tape where the heating element arrangement (44) and the temperature sensor arrangement (38) are sintered in the ceramic heater (12) in one sintering step and the heating element arrangement (44) and the temperature sensing arrangement (38) are completely embedded within the ceramic composite (26-36).

16. The method of claim 15, further comprising a step of providing a conductive pathway (40) within said ceramic composite (26-36) to said heating element arrangement (44) and to said temperature sensor arrangement (38).

17. The method of claim 15, further comprising a step of attaching a lead wire (42) to said conductive pathway (40).

18. The method of claim 15, wherein said one sintering step infiltrates the plurality of layers (26-36) of tape and the temperature sensor arrangement (38) into one another to completely embed the temperature sensor arrangement (38) within the plurality of layers (26-36) of tape, the tape preferably comprising an aluminum nitride composite.

19. The method of claim 15, wherein the step of applying a temperature sensor arrangement (38) to one of said plurality of layers (26-36) of tape includes a step of applying ink to said one of said plurality of layers (26-36) of tape.

20. The method of claim 19, wherein the ink is selected from a group consisting of molybdenum, and molybdenum combined with aluminum nitride.

21. The method of claim 14, wherein the temperature sensor arrangement (38) includes at least two sensor elements operatively associated with the at least two heating zones (28A, 28B) for individually measuring a temperature of the heating zones (28A, 28B).

## Patentansprüche

1. Keramikheizer (12), umfassend:
ein Keramiksubstrat (26-36), eine Heizelementanordnung (44) und eine Temperatursensoranordnung (38), wobei die Temperatursensoranordnung (38) in Wirkverbindung mit der Heizelementanordnung (44) verbunden ist, **dadurch gekennzeichnet, dass;**
a) das Keramiksubstrat ein einzelnes Keramikmaterial festlegt;
b) die Heizelementanordnung (44) in dem Keramiksubstrat (26-36) direkt eingebettet ist; und
c) die Temperatursensoranordnung (38) in dem Keramiksubstrat (26-36) vollständig eingebettet ist; wobei man das Keramiksubstrat (26-36) und die Temperatursensoranordnung (38) ineinander eindringen lässt, um die Temperatursensoranordnung (38) im Keramiksubstrat (26-36) vollständig einzubetten.

2. Keramikheizer (12) nach Anspruch 1, weiter umfassend eine Hohlwelle (18), die an dem Keramiksubstrat (26-36) angebracht ist.

3. Keramikheizer (12) nach Anspruch 1, bei dem sich das Keramiksubstrat (26-36) aus einem Aluminiumnitridkeramikverbundwerkstoff zusammensetzt.

4. Keramikheizer (12) nach Anspruch 1, bei dem die Temperatursensoranordnung (38) durch einen Mikroprozessor (14) in Wirkverbindung mit der Heizelementanordnung (44) verbunden ist.

5. Keramikheizer (12) nach einem der vorangehenden Ansprüche, bei dem die Heizelementanordnung (44) aus einem Material hergestellt ist, das einen niedrigen Temperaturkoeffizienten des Widerstands zeigt.

6. Keramikheizer (12) nach den Ansprüchen 4 oder 5, bei dem die Heizelementanordnung (44) im Keramiksubstrat (26-36) wechselseitig eingebunden ist.

7. Keramikheizer (12) nach einem der vorangehenden Ansprüche, bei dem die Heizelementanordnung (44) eine Mehrzahl von Heizzonen (28A, 28B) festlegt und die Temperatursensoranordnung (38) eine Mehrzahl von Sensorelementen umfasst, die in Wirkverbindung mit der Mehrzahl von Heizzonen (28A, 28B) verbunden sind, um Temperaturen der Heizzonen (28A, 28B) einzeln zu messen.

8. Keramikheizer (12) nach einem der vorangehenden Ansprüche, weiter umfassend einen Stromleitungsweg (40), der mit der Heizelementanordnung (44) und mit der Temperaturerfassungsanordnung (38) verbunden ist.

9. Keramikheizer (12) nach einem der vorangehenden Ansprüche, weiter umfassend einen Leitungsdraht (42), der mit dem Stromleitungsweg (40) verbunden ist, wobei der Leitungsdraht (42) vorzugsweise aus Nickel aufgebaut ist.

10. Keramikheizer (12) nach Anspruch 8 oder Anspruch 9, bei dem die Temperaturerfassungsanordnung (38), die Heizelementanordnung (44) oder der Stromleitungsweg (40) aus einem Verbundwerkstoff aus Molybdän und Aluminiumnitrid zusammensetzt ist.

11. Verfahren zum Einwirkenlassen einer konstanten und gleichförmigen Wärmequelle auf einen Gegenstand, **dadurch gekennzeichnet, dass** das Verfahren die Schritte umfasst:
a) Bereitstellen eines Keramikheizers (12), umfassend:
i. ein Keramiksubstrat (26-36), das ein einzelnes Keramikmaterial festlegt,
ii. eine Heizelementanordnung (44), die im Innern des Keramiksubstrats (26-36) direkt eingebettet ist, wobei die Heizelementanordnung (44) mindestens zwei unabhängige und abgesonderte Heizzonen (28A, 28B) bildet, und
iii. eine Temperatursensoranordnung (38), die in dem Keramiksubstrat (26-36) vollständig eingebettet ist, wobei die Temperatursensoranordnung (38) in Wirkverbindung mit der Heizelementanordnung (44) verbunden ist, wobei man das Keramiksubstrat (26-36) und die Temperatursensoranordnung (38) ineinander eindringen lässt, um die Temperatursensoranordnung (38) im Keramiksubstrat (26-36) vollständig einzubetten;
b) Platzieren des Gegenstands in Verbindung mit dem Keramikheizer (12);
c) Ermöglichen, dass die Temperatursensoranordnung (38) unterschiedliche Temperaturen entlang der Oberfläche des Gegenstands detektiert; und
d) Einstellen der Heizelementanordnung (44), um die unterschiedlichen Temperaturen entlang dem Gegenstand zu beseitigen.

12. Verfahren nach Anspruch 11, bei dem der Gegenstand eine Halbleiterscheibe ist.

13. Verfahren nach Anspruch 11, bei dem der Schritt einer Einstellung der Heizelementanordnung (44) durch einen Mikroprozessor (14) bewerkstelligt wird, der die Heizelementanordnung (44) im Betrieb steuert.

14. Verfahren nach Anspruch 11, bei dem der Schritt einer Beseitigung der unterschiedlichen Temperaturen durch die Heizelementanordnung (44) bewerkstelligt wird, die mehr Wärme zu kälteren Bereichen des Gegenstands und weniger Wärme zu wärmeren Bereichen des Gegenstands zuführt.

15. Verfahren zur Herstellung eines Keramikheizers (12) zum Heizen einer Halbleiterscheibe in einer chemischen Gasphasenabscheidungs- und Ätzumgebung, **dadurch gekennzeichnet, dass** das Verfahren die Schritte umfasst:
a) Bereitstellen einer Mehrzahl von Lagen (26-36) eines Bands;
b) Platzieren einer Heizelementanordnung (44) in der Form eines eingebundenen Bands in einer von der Mehrzahl von Lagen (26-36) eines Bands;
c) Aufbringen einer Temperaturerfassungsanordnung (38) auf eine von der Mehrzahl von Lagen (26-36) eines Bands;
d) Zusammenstellen der Mehrzahl von Lagen (26-36) eines Bands; und
e) Bilden eines Keramikverbundwerkstoffs aus der Mehrzahl von Lagen (26-36) eines Bands, wobei die Heizelementanordnung (44) und die Temperatursensoranordnung (38) in einem Sinterschritt in den Keramikheizer (12) gesintert werden und die Heizelementanordnung (44) und die Temperaturerfassungsanordnung (38) im Keramikverbundwerkstoff (26-36) vollständig eingebettet werden.

16. Verfahren nach Anspruch 15, weiter umfassend einen Schritt: Bereitstellen eines Stromleitungswegs (40) zu der Heizelementanordnung (44) und zu der Temperatursensoranordnung (38) in dem Keramikverbundwerkstoff (26-36).

17. Verfahren nach Anspruch 15, weiter umfassend einen Schritt: Anbringen eines Leitungsdrahts (42) an den Stromleitungsweg (40).

18. Verfahren nach Anspruch 15, bei dem der eine Sinterschritt die Mehrzahl von Lagen (26-36) eines Bands und die Temperatursensoranordnung (38) ineinander eindringen lässt, um die Temperatursensoranordnung (38) in der Mehrzahl von Lagen (26-36) eines Bands vollständig einzubetten, wobei das Band vorzugsweise einen Aluminiumnitridverbundwerkstoff umfasst.

19. Verfahren nach Anspruch 15, bei dem der Schritt einer Aufbringung einer Temperatursensoranordnung (38) auf eine von der Mehrzahl von Lagen (26-36) eines Bands einen Schritt umfasst: Aufbringen von Tinte auf die eine von der Mehrzahl von Lagen (26-36) eines Bands.

20. Verfahren nach Anspruch 19, bei dem die Tinte aus einer Gruppe ausgewählt wird, die sich aus Molybdän und Molybdän in Kombination mit Aluminiumnitrid zusammensetzt.

21. Verfahren nach Anspruch 14, bei dem die Temperatursensoranordnung (38) mindestens zwei Sensorelemente umfasst, die in Wirkverbindung mit den mindestens zwei Heizzonen (28A, 28B) verbunden sind, um eine Temperatur der Heizzonen (28A, 28B) einzeln zu messen.

## Revendications

1. Réchauffeur de céramique (12) comprenant :
un substrat de céramique (26-36), un agencement d'élément chauffant (44) et un agencement de capteur de température (38), l'agencement de capteur de température (38) étant associé pour fonctionner au dit agencement d'élément chauffant (44), **caractérisé en ce que :**
a) ledit substrat de céramique définit un matériau de céramique unique ;
b) ledit agencement d'élément chauffant (44) est directement encastré à l'intérieur dudit substrat de céramique (26-36) ; et
c) ledit agencement de capteur de température (38) est totalement encastré à l'intérieur dudit substrat de céramique (26-36) ; le substrat de céramique (26-36) et l'agencement de capteur de température (38) étant introduits l'un dans l'autre, afin d'encastrer totalement l'agencement de capteur de température (38) à l'intérieur du substrat de céramique (26-36).

2. Réchauffeur de céramique (12) selon la revendication 1, comprenant en outre un arbre creux (18) fixé au dit substrat de céramique (26-36).

3. Réchauffeur de céramique (12) selon la revendication 1, dans lequel ledit substrat de céramique (26-36) consiste en un composite de céramique au nitrure d'aluminium.

4. Réchauffeur de céramique (12) selon la revendication 1, dans lequel ledit agencement de capteur de température (38) est associé, pour fonctionner, au dit agencement d'élément chauffant (44) par un microprocesseur (14).

5. Réchauffeur de céramique (12) selon l'une quelconque des revendications précédentes, dans lequel ledit agencement d'élément chauffant (44) est composé d'un matériau qui révèle un faible coefficient de résistance à la température.

6. Réchauffeur de céramique (12) selon les revendications 4 ou 5, dans lequel ledit agencement d'élément chauffant (44) est emboîté à l'intérieur du substrat de céramique (26-36).

7. Réchauffeur de céramique (12) selon l'une quelconque des revendications précédentes, dans lequel l'agencement d'élément chauffant (44) définit une pluralité de zones chauffantes (28A, 28B) et l'agencement de capteur de température (38) inclut une pluralité d'éléments formant capteur associés, pour fonctionner, avec la pluralité de zones chauffantes (28A, 28B), afin de mesurer séparément les températures des zones chauffantes (28A, 28B).

8. Réchauffeur de céramique (12) selon l'une quelconque des revendications précédentes comprenant en outre une voie conductrice (40) qui est connectée au dit agencement d'élément chauffant (44) et au dit agencement de capteur de température (38).

9. Réchauffeur de céramique (12) selon l'une quelconque des revendications précédentes, comprenant en outre un fil conducteur (42) connecté à ladite voie conductrice (40), le fil conducteur (42) étant de préférence composé de nickel.

10. Réchauffeur de céramique (12) selon la revendication 8 ou la revendication 9, dans lequel ledit agencement de capteur de température (38), ledit agencement d'élément chauffant (44) ou la voie conductrice (40) est composée d'un composite de molybdène et de nitrure d'aluminium.

11. Procédé d'application d'une source de chaleur constante et uniforme sur un article, **caractérisé en ce que** le procédé comprend les étapes consistant à :
a) fournir un réchauffeur de céramique (12) comprenant :
i. un substrat de céramique (26-36) définissant un matériau de céramique unique,
ii. un agencement d'élément chauffant (44) directement encastré à l'intérieur dudit substrat de céramique (26-36), l'agencement d'élément chauffant (44) formant au moins deux zones chauffantes indépendantes distinctes (28A, 28B) et
iii. un agencement de capteur de température (38) totalement encastré à l'intérieur dudit substrat de céramique (26-36), l'agencement de capteur de température (38) étant associé au dit agencement d'élément chauffant (44), pour fonctionner, dans lequel le substrat de céramique (26-36) et l'agencement de capteur de température (38) sont introduits l'un dans l'autre afin d'encastrer totalement l'agencement de capteur de température (38) à l'intérieur du substrat de céramique (26-36) ;
b) placer ledit article en communication avec ledit réchauffeur de céramique (12) ;
c) permettre au dit agencement de capteur de température (38) de détecter des températures qui diffèrent le long de la surface dudit article ; et
d) régler ledit agencement d'élément chauffant (44) pour éliminer lesdites températures qui diffèrent le long dudit article.

12. Procédé selon la revendication 11, dans lequel ledit article est une tranche de semi-conducteur.

13. Procédé selon la revendication 11, dans lequel ladite étape de réglage dudit agencement d'élément chauffant (44) est réalisée par un microprocesseur (14) qui se trouve sous la commande de fonctionnement dudit agencement d'élément chauffant (44).

14. Procédé selon la revendication 11, dans lequel ladite étape d'élimination desdites températures qui diffèrent est réalisée par ledit agencement d'élément chauffant (44) qui fournit plus de chaleur à des zones plus fraîches dudit article et moins de chaleur à des zones plus chaudes dudit article.

15. Procédé de fabrication d'un réchauffeur de céramique (12) destiné à chauffer une tranche de semi-conducteur dans un environnement d'attaque et de dépôt en phase vapeur, **caractérisé en ce que** le procédé comprend les étapes consistant à :
a) fournir une pluralité de couches (26-36) de bande ;
b) placer un agencement d'élément chauffant (44) sous la forme d'une bande collée à l'intérieur de l'une de ladite pluralité de couches (26-36) de bande ;
c) appliquer un agencement de capteur de température (38) sur l'une de ladite pluralité de couches (26-36) de bande ;
d) réunir ladite pluralité de couches (26-36) de bande ; et
e) former un composite de céramique à partir de ladite pluralité de couches (26-36) de bande lorsque l'agencement d'élément chauffant (44) et l'agencement de capteur de température (38) sont frittés dans le réchauffeur de céramique (12) au cours d'une étape de frittage et l'agencement d'élément chauffant (44) et l'agencement de capteur de température (38) sont totalement encastrés à l'intérieur du composite de céramique (26-36).

16. Procédé selon la revendication 15, comprenant en outre une étape consistant à fournir une voie conductrice (40) à l'intérieur dudit composite de céramique (26-36) au dit agencement d'élément chauffant (44) et au dit agencement de capteur de température (38).

17. Procédé selon la revendication 15, comprenant en outre une étape de fixation d'un fil conducteur (42) sur ladite voie conductrice (40).

18. Procédé selon la revendication 15, dans lequel ladite une étape de frittage introduit la pluralité de couches (26-36) de bande et l'agencement de capteur de température (38) l'un dans l'autre, afin d'encastrer totalement l'agencement de capteur de température (38) à l'intérieur de la pluralité de couches (26-36) de bande, la bande comprenant de préférence un composite de nitrure d'aluminium.

19. Procédé selon la revendication 15, dans lequel l'étape de l'application d'un agencement de capteur de température (38) sur l'une de ladite pluralité de couches (26-36) de bande inclut une étape d'application d'encre sur ladite une couche de ladite pluralité de couches (26-36) de bande.

20. Procédé selon la revendication 19, dans lequel l'encre est choisie dans un groupe consistant en le molybdène, et le molybdène combiné avec du nitrure d'aluminium.

21. Procédé selon la revendication 14, dans lequel l'agencement de capteur de température (38) inclut au moins deux éléments formant capteur associés pour fonctionner avec les au moins deux zones chauffantes (28A, 28B) afin de mesurer séparément une température des zones chauffantes (28A, 28B).
